# FASCICULE DE BREVET EUROPEEN

(11) **EP 3 182 588 B1**
(45) Date de publication et mention de la délivrance du brevet: **20.02.2019**
(21) Numéro de dépôt: 16204612.2
(22) Date de dépôt: 16.12.2016
(51) Int. Cl.: H03H 7/40, H03H 11/30, H04B 1/10, H04B 1/18, H04B 1/12

(54) **ADAPTATION AUTOMATIQUE D'IMPÉDANCE D'UNE CHAÎNE DE RÉCEPTION À RADIOFRÉQUENCE**
AUTOMATISCHE ANPASSUNG DER IMPEDANZ EINES FUNKEMPFÄNGERS
AUTOMATIC ADAPTATION OF THE IMPEDANCE OF A RADIOFREQUENCY RECEIVER

(30) Priorité: 17.12.2015 FR 1562673
(43) Date de publication de la demande: 21.06.2017
(73) Titulaire: COMMISSARIAT À L'ÉNERGIE ATOMIQUE ET AUX ÉNERGIES ALTERNATIVES, 75015 Paris (FR)
(72) Inventeur: DE FOUCAULD, Emeric, 38500 COUBLEVIE (FR); TARIS, Thierry, 33405 TALENCE (FR)
(74) Mandataire: Priori, Enrico

(56) Documents cités:
- JP-A- 2013 070 143
- US-A1- 2008 129 610

## Description

L'invention porte sur un procédé d'adaptation automatique d'impédance d'une chaîne de réception à radiofréquence, et plus spécifiquement sur un procédé d'adaptation automatique d'antenne. L'invention porte également sur une chaîne de réception à radiofréquence permettant la mise en oeuvre d'un tel procédé.

Dans certaines applications de transmission d'informations en radiofréquence, on a constaté que l'antenne d'émission ou de réception pouvait avoir une impédance dépendant fortement de conditions extérieures à l'antenne, et dépendant notamment du milieu dans lequel l'antenne est placée.

Par exemple, dans la télémétrie médicale, on peut être amené à introduire l'antenne dans une sonde placée dans le corps humain, et l'impédance dépend alors fortement du milieu biologique dans lequel l'antenne se trouve. Elle dépend des propriétés électriques (conductivité, constante diélectrique) des tissus environnants (muscles, graisse) ou du milieu liquide (sang, autres liquides) dans lequel l'antenne peut être immergée.

Même dans des applications plus conventionnelles de transmission radiofréquence (téléphonie mobile, etc.) l'impédance de l'antenne peut varier.

De manière générale, les variations d'impédance d'antenne sont particulièrement sensibles pour des antennes de très petites dimensions ayant un fort coefficient de qualité, utilisées dans les applications à fortes contraintes de miniaturisation.

Ces variations d'impédance peuvent entraîner des pertes dites pertes de désadaptation : ces pertes résultent de ce que la chaîne d'émission qui alimente l'antenne, ou la chaîne de réception qui reçoit un signal de l'antenne, est en général conçue pour avoir des performances optimales lorsqu'elle est chargée (en sortie pour la chaîne d'émission ou en entrée pour la chaîne de réception) par une impédance nominale bien déterminée ; elle a des performances dégradées lorsqu'elle est chargée par une impédance différente de sa valeur nominale. Les pertes de désadaptation peuvent aller jusqu'à 40 dB.

C'est pourquoi il est connu d'interposer, entre la sortie d'un amplificateur de puissance et l'antenne d'une chaîne d'émission, un réseau d'adaptation d'impédance, en anglais « matching network », qui fait que la chaîne d'émission voit une impédance différente de celle de l'antenne et de préférence égale à la valeur nominale pour laquelle elle a été conçue, par exemple 100 ohms ou 500 ohms. Le réseau d'adaptation est accordable, c'est-à-dire que ses éléments, capacitifs et/ou inductifs, ont des valeurs ajustables pour tenir compte des conditions d'environnement de l'antenne de telle sorte que l'adaptation soit la meilleure possible quelles que soient les circonstances. De même, il est connu d'interposer un tel réseau d'adaptation d'impédance entre l'antenne d'une chaîne de réception et l'entrée d'un amplificateur à bas bruit.

Plusieurs techniques ont été proposées pour accorder de manière automatique un tel réseau d'adaptation, de manière à suivre, par exemple, des variations de l'impédance d'antenne induites par des conditions extérieures.

Le document US 4 375 051 enseigne l'utilisation, dans un chaîne d'émission, d'un coupleur bidirectionnel pour détecter une désadaptation par mesure de la fraction de la puissance fournie par un amplificateur qui est réfléchie par l'antenne. Cette mesure sert à asservir le réseau d'impédance pour modifier sa configuration dans un sens tendant à réduire la puissance réfléchie. Ce procédé souffre de deux inconvénients : d'une part la puissance réfléchie peut être faible et sujette à des interférences parasites, car toute interférence captée par l'antenne vient fausser la mesure du fait qu'elle s'additionne à la puissance réfléchie. D'autre part il n'y a pas de relation biunivoque entre la quantité de puissance réfléchie, qui sert d'entrée à l'asservissement, et la valeur complexe d'impédance qu'il faudrait donner au réseau d'adaptation pour adapter vraiment l'amplificateur à l'antenne. Ce procédé conduit donc à une nouvelle impédance qui n'est pas nécessairement optimale, car à une puissance donnée correspondent plusieurs couples d'impédances complexes.

Le document US 2009/0130991 divulgue un procédé d'ajustement des valeurs des réactances d'un circuit d'adaptation d'impédance agencé entre une antenne de réception et un amplificateur à bas bruit dans lequel les réactances des éléments dudit circuit d'adaptation sont ajustées itérativement de façon à maximiser l'intensité du signal de sortie dudit amplificateur à bas bruit. La convergence de l'algorithme d'optimisation itérative peut être très lente.

Les documents EP 2 037 576, WO 2011/026858, EP 2 509 222 et EP 2 509 227 décrivent diverses variantes d'un procédé d'adaptation automatique d'impédance d'une chaîne d'émission ou réception radiofréquence, dans lequel des mesures de courant et de tension à l'entrée (pour une chaîne d'émission) ou à la sortie (pour une chaîne de réception) du réseau d'adaptation permettent de déterminer l'impédance d'antenne. La connaissance ainsi obtenue de l'impédance d'antenne permet d'utiliser des techniques classiques, par exemple basées sur un abaque de Smith, pour ajuster les valeurs d'impédance des éléments du réseau d'adaptation de manière à parvenir à une adaptation d'impédance.

Ces techniques fonctionnent bien en émission, mais leur application aux chaînes de réception est beaucoup plus délicate. En effet, la puissance du signal en sortie d'antenne est très faible, et il est difficile d'en prélever une partie pour effectuer les mesures permettant l'adaptation d'impédance ; dans le meilleur des cas, cela nécessite l'utilisation de circuits de détection à haute précision, très complexes et coûteux. Pour pallier cet inconvénient, il a été proposé d'effectuer les mesures de tension et de courant à la sortie de l'amplificateur d'antenne (amplificateur à bas bruit, ou LNA de l'anglais « Low-Noise Amplifier »). Toutefois, cela n'est pas toujours possibles car certains LNA sont conçu de manière à présenter une impédance de sortie sensiblement indépendante de leur impédance d'entrée : dans ce cas, des mesures effectuées à la sortie de l'amplificateur ne permettent pas de déterminer l'impédance d'antenne. Il a également été proposé de procéder de manière dichotomique, en réglant le circuit d'adaptation de façon à maximiser la puissance en sortie du LNA sans procéder à une mesure préalable de l'impédance d'antenne. Cette solution n'est pas satisfaisante car, en l'absence de précautions particulières, la maximisation de la puissance de sortie peut résulter d'un niveau de bruit très élevé, ce qui n'est pas acceptable.

Les documents US 2008/129610 et JP 2013/070143 divulguent des techniques d'adaptation automatique permettant d'optimiser à la fois le gain et le niveau de bruit. Ces méthodes procèdent par essais ; elles sont donc relativement lentes, et le fonctionnement de la chaîne de réception est fortement perturbé pendant la durée de la phase d'adaptation.

L'invention vise à procurer une technique d'adaptation automatique d'impédance d'une chaîne de réception à radiofréquence permettant de surmonter les inconvénients précités de l'art antérieur.

Conformément à l'invention, ce but est atteint en accordant le réseau d'adaptation en fonction du gain de la chaîne de réception et du niveau de bruit - exprimé par exemple par le rapport signal sur bruit (SNR, de l'anglais Signal-to-Noise Ratio) - mesuré en sortie du LNA. Plus particulièrement, ces deux mesures permettent de déterminer l'impédance d'antenne et de procéder ainsi de manière directe à une adaptation d'impédance.

Un objet de l'invention est donc un procédé d'adaptation automatique d'impédance d'une chaîne de réception à radiofréquence comprenant : une antenne, un amplificateur et un réseau d'adaptation d'impédance configurable agencé entre ladite antenne et une entrée dudit amplificateur, le procédé comprenant les étapes suivantes :
a) l'acquisition d'au moins une mesure du gain de la chaîne de réception et du niveau de bruit en sortie de l'amplificateur ; et
b) l'accord dudit réseau d'adaptation en fonction desdites mesures ;
caractérisé en ce que ladite étape b) comprend les sous-étapes suivantes :
b1) la détermination d'une impédance vue depuis l'entrée de l'amplificateur à partir des mesures de l'étape a) ;
b2) le calcul d'une impédance de l'antenne à partir de l'impédance déterminée lors de la sous-étape précédente et de la fonction de transfert du réseau d'adaptation d'impédance ; et
b3) l'accord dudit réseau d'adaptation de manière à réaliser une adaptation d'impédance entre l'antenne et l'amplificateur.

Un autre objet de l'invention est une chaîne de réception à radiofréquence comprenant : une antenne, un amplificateur et un réseau d'adaptation d'impédance configurable, agencé entre ladite antenne et une entrée dudit amplificateur, caractérisée en ce qu'elle comprend aussi : des circuits de mesure du gain de la chaîne de réception et du niveau de bruit en sortie de l'amplificateur ; un dispositif d'accord dudit réseau d'adaptation d'impédance ; et un processeur de données configuré pour recevoir en entrée des mesures de gain et de niveau de bruit en provenance desdits circuits de mesure et pour fournir en sortie des signaux de pilotage dudit dispositif d'accord ; caractérisée en ce que ledit processeur de données est configuré pour : déterminer une impédance vue depuis l'entrée de l'amplificateur à partir des mesures en provenance desdits circuits de mesure ; calculer une impédance de l'antenne à partir de l'impédance ainsi déterminée et de la fonction de transfert du réseau d'adaptation d'impédance ; et fournir en sortie des signaux de pilotage dudit dispositif d'accord adaptés pour réaliser une adaptation d'impédance entre l'antenne et l'amplificateur. Plus particulièrement, ledit processeur de données peut être configuré pour déterminer ladite impédance vue depuis l'entrée de l'amplificateur par application d'une table de correspondance.

D'autres caractéristiques, détails et avantages de l'invention ressortiront à la lecture de la description faite en référence aux dessins annexés donnés à titre d'exemple et qui représentent, respectivement :
- Les figures 1A à 1G, une simulation informatique permettant d'illustrer le problème technique et les principes de la solution apportée par l'invention ;
- La figure 2, le schéma d'une chaîne de réception à radiofréquence selon un mode de réalisation de l'invention ;
- Les figures 3A, 3B et 3C, des courbes du facteur de bruit et du gain de la chaîne de réception de la figure 2 en fonction de la partie réelle et de la partie imaginaire de l'impédance d'antenne ; et
- La figure 4, l'organigramme d'un procédé d'adaptation d'impédance selon un mode de réalisation de l'invention.

On entend par « radiofréquence » toute fréquence comprise entre 3 kHz et 300 GHz.

On entend par « amplificateur à bas bruit » un amplificateur dont une entrée est reliée ou destinée à être reliée, de manière directe ou indirecte, à une antenne réceptrice.

On entend par « élément réactif » un composant électrique dont l'impédance présente, à au moins une fréquence dans le domaine radiofréquence, une composante réactive (capacitive ou inductive) supérieure ou égale - et de préférence supérieure d'un facteur 10 ou plus - à sa composante résistive.

On considèrera dans la suite que les signaux dans le réseau d'adaptation présentent une fréquence unique f=ω/2π, ce qui permet de caractériser un élément capacitif ou inductif (élément réactif) par une valeur de réactance. Cette approximation est généralement satisfaisante dans le domaine des radiofréquences.

On entend par « adaptation d'impédance » une condition dans laquelle le transfert de puissance électrique à radiofréquence entre une source (ici, l'antenne) et une charge (ici, l'amplificateur à bas bruit) est optimal. L'adaptation d'impédance au sens strict correspond à la condition où l'impédance d'entrée de l'amplificateur à bas bruit, vue par l'antenne, est égale au complexe conjugué de l'impédance d'antenne. Toutefois on considèrera dans la suite une notion plus générale de l'adaptation d'impédance, couvrant le cas où un compromis est atteint entre le transfert de puissance, le niveau de bruit du signal à la sortie de l'amplificateur et, le cas échéant, la consommation électrique de l'amplificateur.

On entend par « accord » du réseau d'adaptation d'impédance une modification de sa fonction de transfert, et donc de ses propriétés de transformation d'impédance.

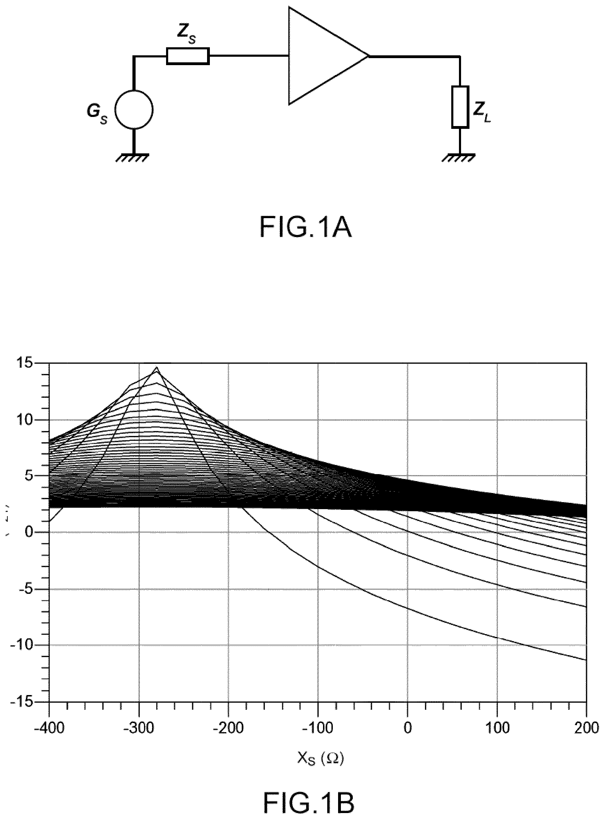

La figure 1A illustre le schéma électrique d'un amplificateur à bas bruit LNA conçu pour un fonctionnement à 1 GHz et convenant à la mise en oeuvre d'une chaîne de réception selon un mode de réalisation de l'invention. Le port d'entrée de ce circuit est relié à un générateur de signaux G_{S} présentant une impédance complexe variable Z_{S} qui modélise une antenne réceptrice, d'impédance Z_{ANT}, reliée à un réseau d'adaptation d'impédance. Son port de sortie est relié à une impédance de charge dont la valeur Z_{L} est, de manière conventionnelle, de 50 Ohm.

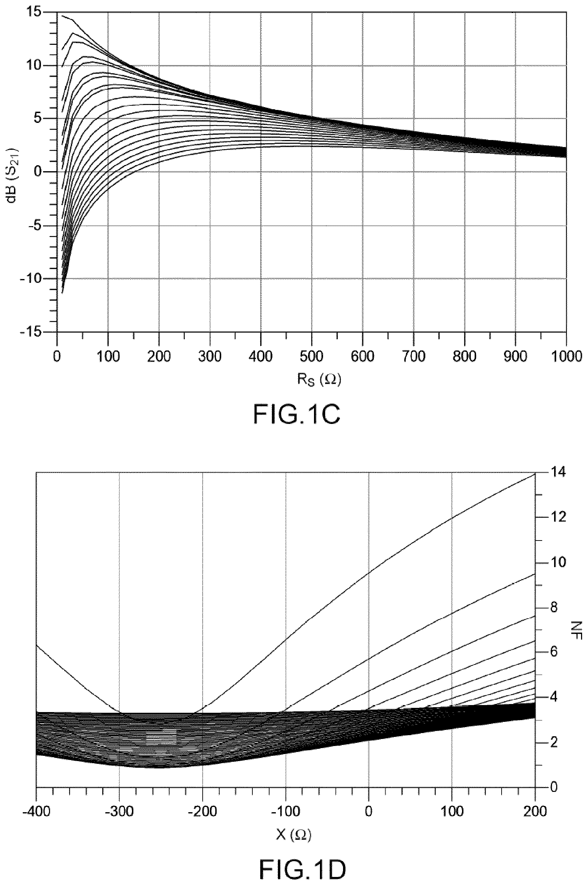

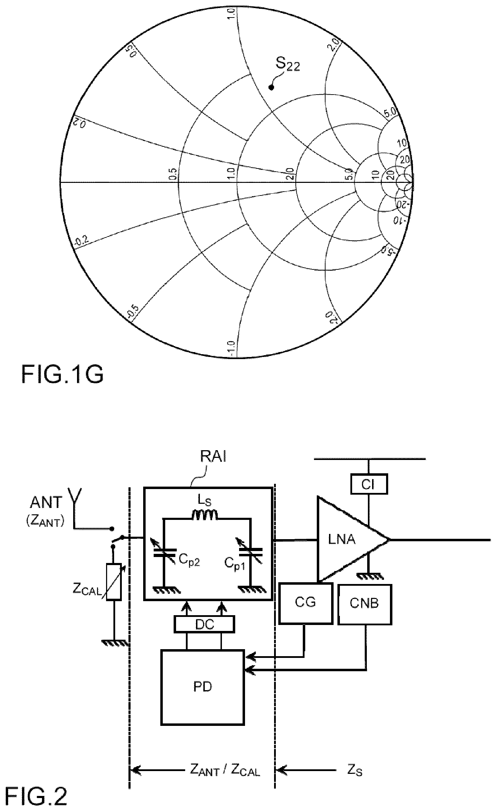

La figure 1B illustre la dépendance du gain (en dB) mesuré entre le générateur de signaux et la sortie de l'amplificateur, ce qui correspond au paramètre S₂₁ de la matrice S du système, de la partie imaginaire (réactive) X_{S} de l'impédance Z_{S} pour différentes valeurs - comprises entre 0 et 1000 Ω - de sa partie réelle (résistive) R_{S.} La figure 1C montre la dépendance du gain de R_{S}, pour différents valeur de X_{S} compris entre -400 Ω et 200 Ω. On peut vérifier que le gain prend une valeur maximale pour Z_{S}=10-280 j Ω, j étant l'unité imaginaire. En général, l'impédance d'antenne Z_{ANT}=R_{ANT}+j X_{ANT} prendra une valeur différente, et même variable dans le temps, d'où la nécessité d'introduire, entre l'antenne et le port d'entrée de l'amplificateur, un réseau d'adaptation d'impédance. Dans le schéma de la figure 2, par exemple, on utilise un circuit réactif à éléments concentrés (filtre) RAI présentant une topologie en « Pi », mais d'autres types de circuits, à paramètres concentrés ou distribués, sont connus de l'homme du métier et conviennent à la mise en oeuvre de l'invention.

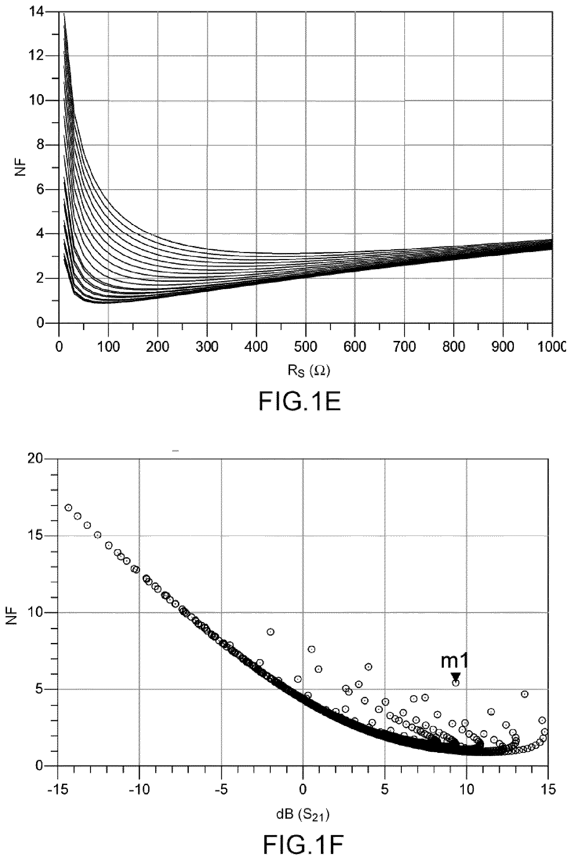

Le facteur de bruit NF de l'amplificateur - qui influence le niveau de bruit à sa sortie - est également affecté par l'impédance d'antenne. Les figures 1D et 1E illustrent la dépendance de NF (représenté sur une échelle linéaire) de X_{S} et R_{S} respectivement. On peut vérifier que le facteur de bruit prend une valeur minimale pour Z_{S}=230-250 j Ω.

La figure 1F synthétise ces résultats exprimant NF en fonction de S₂₁ pour différentes valeurs de Z_{S}, où R_{S} varie entre 5 et 1000 Ω et X_{S} entre - 200 et 400 Ω. Cette figure confirme que, s'il n'est pas possible de minimiser NF et maximiser S₂₁ en même temps, il est néanmoins possible d'obtenir un compromis satisfaisant entre ces deux paramètres ; on parle alors d'optimisation simultanée du gain et du niveau de bruit (ce dernier étant proportionnel à NF pour un signal d'entrée déterminé). Concrètement, il pourra s'agir de maximiser ou minimiser une fonction-objectif - par exemple linéaire - de NF et de S₂₁, ou bien de maximiser NF sous contrainte d'une valeur minimale de S₂₁ (exprimée en valeur absolue ou comme pourcentage de la valeur maximale possible), ou réciproquement.

La valeur-cible de Z_{S} permettant d'atteindre cet optimum dépend à la fois de l'impédance d'antenne Z_{ANT} et de la fonction de transfert du réseau d'adaptation d'impédance RAI. La première étant variable dans le temps, la deuxième doit être modifiée en conséquence. Malheureusement, comme cela a été évoqué plus haut, il est difficile de déterminer Z_{ANT} à partir de mesures effectuées directement en sortie d'antenne, ou même à l'entrée de l'amplificateur LNA, et il est généralement impossible de le faire à partir de mesures effectuées à la sortie du LNA. Ce dernier point est illustré par la figure 1G, qui représente, sur un abaque de Smith, l'impédance de sortie S₂₂ du LNA en fonction de Z_{S}. Cette représentation se réduit à un point ; en d'autres termes l'impédance de sortie S₂₂ du LNA est tout à fait indépendante de l'impédance de source Z_{S}. Cela signifie que des mesures de courant et de tension effectuées à la sortie du LNA permettent uniquement de déterminer S₂₂, mais pas de remonter à Z_{S} et donc à Z_{ANT}.

Pour remédier à cette difficulté, l'invention propose de mesurer, au moyen de circuits de mesure appropriés, le niveau de bruit SNR et le gain G à la sortie de l'amplificateur à bas bruit LNA, comme cela est représenté de manière schématique sur la figure 2. Un processeur de données PD traite ces mesures selon un algorithme qui sera décrit plus loin et génère des signaux de pilotage d'un dispositif d'accord DA qui agit - électriquement et/ou mécaniquement - sur les éléments réactifs C_{P1}, C_{P2}, L_{S} du réseau d'adaptation RAI pour modifier leur réactance et, par conséquent, leur fonction de transfert qui lie l'impédance d'antenne Z_{ANT} à l'impédance Z_{S} vue par le port d'entrée de l'amplificateur LNA et qui influence ses performances comme cela a été montré par les figures 1B - 1F.

Le capteur de gain CG peut être un simple capteur de tension connecté à la sortie de l'amplificateur LNA. En effet, on peut considérer que cette tension de sortie - par exemple sa valeur quadratique moyenne (rms) - est représentative du gain de l'amplificateur.

La réalisation d'un capteur de niveau de bruit CNB est plus délicate. On peut procéder, par exemple, à une mesure de la tension quadratique moyenne de sortie du LNA lorsque son entrée est reliée à une impédance adaptée, en l'absence de signal (ce qui peut être effectué de manière automatique en prévoyant une telle impédance connectée à l'entré par l'intermédiaire d'interrupteur commandés), mais cela perturbe le fonctionnement normal de la chaîne de réception. Dans le cas où la chaîne de réception alimente une chaîne d'acquisition de signal numérique, il est possible de procéder - à l'intérieur de cette dernière - à une mesure du taux d'erreur binaire (BER), rendue possible par l'utilisation d'un codage de canal, à partir duquel, connaissant le type de modulation utilisée, on peut remonter au rapport signal sur bruit (SNR) en bout de chaîne. Ensuite le rapport signal sur bruit à la sortie du LNA, et donc le facteur de bruit de ce dernier, peuvent être déterminées par application de la formule de Friis pour le bruit. En outre, la connaissance du rapport signal sur bruit, obtenue par la mesure du BER, et celle du facteur de bruit, permettent de remonter au gain du LNA, supposant le gain des autres éléments de la chaîne connu.

Le niveau de bruit peut aussi être estimé en fournissant en entrée du LNA un signal d'étalonnage connu, par exemple une sinusoïde pure, et en comparant ce signal d'étalonnage au signal amplifié. Par exemple, un signal d'étalonnage mono-fréquentiel présentera des passages par zéro espacés régulièrement (espacement égal à une demi-période). Par contre, dans le signal amplifié par le LNA, le bruit de phase introduit des écarts aléatoires de la périodicité des passages par zéro. L'amplitude de ces écarts peut être mesurée et quantifie le facteur de bruit.

Plus généralement, toute technique d'estimation du niveau de bruit connue de l'homme du métier pourra être utilisée pour la mise en oeuvre de l'invention.

Le processeur de données PD est typiquement un microprocesseur programmé de manière opportune, mais il peut également s'agir d'un circuit numérique configuré de manière matérielle, ou d'une combinaison des deux.

Le dispositif d'accord DA peut comprendre des générateurs de tension permettant de varier la capacité de diodes à capacité variable et des générateurs de courant permettant de varier l'inductance de selfs présentant un noyau saturable ; il existe également des inductances commandées en tension, ainsi que des inductances accordables de type micro-électro-mécanique (MEMS), voir par exemple :
- Casha, O. ; Grech, I. ; Micallef, J. ; Gatt, E. ; Morche, D. ; Viala, B.; Michel, J.P. ; Vincent, P. ; de Foucauld, E. : « Utilization of MEMS Tunable Inductors in the design of RF voltage-controlled oscillators », 15th IEEE International Conférence on Electronics, Circuits and Systems, 2008. ICECS 2008 ;
- L. Collot, J. Lintignat, B. Viala, D. Morche, J-P. Michel, B. Barelaud, B. Jarry « Reconfigurable Filtering Differential Low Noise Amplifier Using MEMS Tunable Inductor » Proceedings of the 40th European Microwave Conference, 2010, Pages: 826 - 829.

Le dispositif d'accord DA peut également comprendre des interrupteurs permettant de connecter ou déconnecter des éléments réactifs, et/ou de modifier la topologie du réseau d'adaptation.

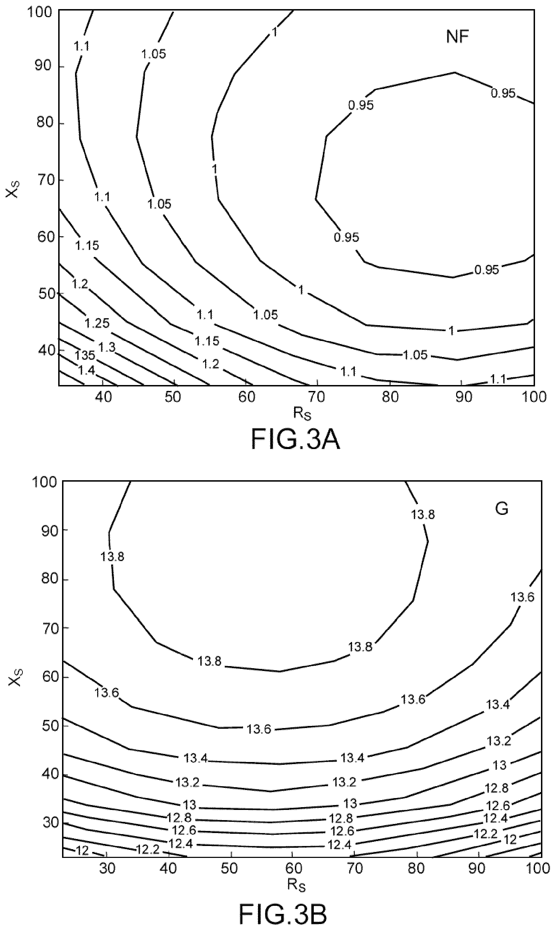

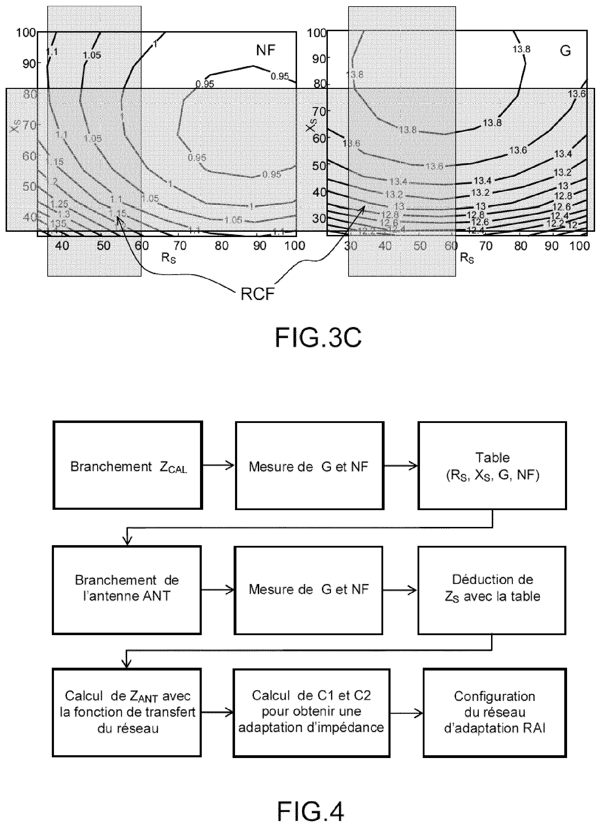

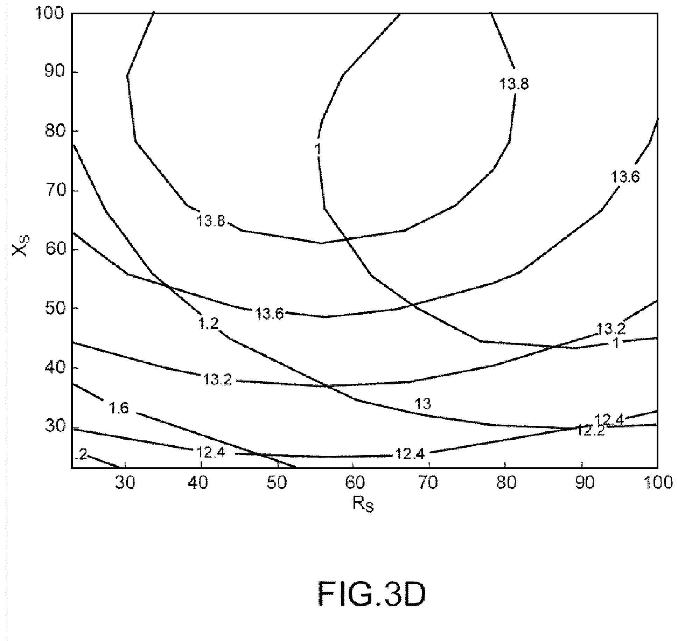

Les figures 3A et 3B montrent, respectivement, des courbes de niveau du facteur de bruit NF et du gain G en fonction de l'impédance Z_{S} vue depuis le port d'entrée de l'amplificateur LNA. Or, en pratique, les parties réelles et imaginaires de l'impédance d'antenne Z_{ANT}, et donc aussi de Z_{S}, ne peuvent varier que dans des plages limitées. Ainsi, seules les régions désignées par le symbole de référence RCF sur la figure 3C correspondent à des conditions de fonctionnement susceptibles d'être rencontrées dans le fonctionnement normal de la chaîne de réception. Dans la plupart des cas, si on se limite à ces régions de fonctionnement, il est possible de définir une relation bijective entre (NF, G) et l'impédance complexe Z_{S} ; cela est illustré par la figure 3D qui superpose les courbes des figures 3A et 3B ; on peut vérifier que pour une valeur d'impédance complexe il n'existe qu'un seul croisement entre courbes de niveau de NF et de G. Autrement dit, une mesure du gain et du niveau de bruit permet de déterminer la valeur de l'impédance d'entrée Z_{S} ; pour cela, le processeur de données PD peut simplement utiliser une table de correspondance établie lors d'une phase préalable d'étalonnage.

A partir de la valeur de Z_{S} ainsi déterminée, le processeur de données PD peut, en supposant connue la fonction de transfert du réseau d'adaptation RAI, calculer l'impédance d'antenne Z_{ANT}.

Une fois connue Z_{ANT}, le processeur de données PD peut déterminer l'accord du réseau d'adaptation RAI permettant d'obtenir une adaptation d'impédance « au sens strict », telle que définie plus haut.

Les processus est illustré par l'organigramme de la figure 4.

Tout d'abord, une impédance variable d'étalonnage Z_{CAL} est branchée à l'entrée de la chaîne de réception à la place de l'antenne. La valeur de Z_{CAL} est faite varier de manière contrôlée alors que la configuration, et donc l'accord, du réseau d'adaptation d'impédance ZAI est maintenue constante (il est même possible de déconnecter et contourner ce réseau). Le gain G et le facteur de bruit NF sont mesurés, ou déduits de mesures de tension et de SNR. Cela permet de construire une table de correspondance reliant (G, NF) aux parties réales et imaginaires R_{CAL}, X_{CAL} de l'impédance d'étalonnage.

Puis l'antenne ANT, présentant une impédance inconnue et variable dans le temps de manière non contrôlée, Z_{ANT}, est branchée à la place de l'impédance d'étalonnage ; sur la figure 2, un commutateur permet de brancher de manière sélective l'antenne ou l'impédance variable d'étalonnage. Le gain G et le facteur de bruit NF sont encore mesurés, ces mesures étant répétées à des intervalles réguliers ou lorsqu'une dégradation des performances de la chaîne est constatée (exprimée, par exemple, par une augmentation du taux d'erreur binaire). Par application de la table de correspondance calculée lors de la phase d'étalonnage, le processeur PD détermine la valeur Z_{S} de l'impédance vue depuis le port d'entrée du LNA, qui est fonction de Z_{ANT} (inconnue) et de la fonction de transfert du réseau d'adaptation RAI (connue). Ensuite, des calculs bien connus dans leur principe permettent de déterminer la valeur de Z_{ANT}, puis les valeurs des réactances du réseau RAI permettant de réaliser une adaptation d'impédance (par exemple C_{P1} et C_{P2}, en supposant L_{S} invariable). Le processeur PD génère alors les signaux de pilotage appropriés du dispositif d'accord DA, de telle sorte que l'adaptation d'impédance soit effectivement réalisée.

Au cas (peu probable) où plusieurs valeurs de Z_{S} conduiraient à une même paire (gain, niveau de bruit), il suffirait de tester les configurations correspondantes du réseau d'adaptation d'impédance et de choisir celle maximisant le gain et/ou minimisant le niveau de bruit.

Par ailleurs, il est possible que, dans certains cas, plusieurs configurations distinctes du réseau RAI (c'est-à-dire plusieurs ensemble de valeurs de ses réactances) permettent d'obtenir une adaptation d'impédence. Dans ce cas, il est avantageux de choisir la configuration qui minimise la consommation du LNA. Elle peut être trouvée en testant les différentes configurations et en effectuant, pour chacune d'entre elles, une mesure du courant d'alimentation du LNA (capteur de courant CI représenté sur la figure 2), ou en utilisant un tableau établi par étalonnage préalable.

## Revendications

1. Procédé d'adaptation automatique d'impédance d'une chaîne de réception à radiofréquence comprenant : une antenne (ANT), un amplificateur (LNA) et un réseau d'adaptation d'impédance configurable (RAI) agencé entre ladite antenne et une entrée dudit amplificateur, le procédé comprenant les étapes suivantes :
a) l'acquisition d'au moins une mesure du gain (G) de la chaîne de réception et du niveau de bruit (SNR) en sortie de l'amplificateur ; et
b) l'accord dudit réseau d'adaptation en fonction desdites mesures ;
**caractérisé en ce que** ladite étape b) comprend les sous-étapes suivantes :
b1) la détermination d'une impédance (Z_{S}) vue depuis l'entrée de l'amplificateur à partir des mesures de l'étape a) ;
b2) le calcul d'une impédance de l'antenne (Z_{ANT}) à partir de l'impédance déterminée lors de la sous-étape précédente et de la fonction de transfert du réseau d'adaptation d'impédance ; et
b3) l'accord dudit réseau d'adaptation de manière à réaliser une adaptation d'impédance entre l'antenne et l'amplificateur.

2. Procédé selon la revendication 1 dans lequel ladite sous-étape b1) est mise en oeuvre par application d'une table de correspondance.

3. Procédé selon l'une des revendications précédentes dans lequel ladite étape a) comprend la mesure d'un taux d'erreur binaire d'un signal numérique reçu par ladite chaîne de réception à radiofréquence, et le calcul dudit niveau de bruit en sortie de l'amplificateur en fonction de ce taux d'erreur binaire.

4. Procédé selon l'une des revendications précédentes dans lequel l'étape b3) comprend la détermination d'une pluralité de configurations du réseau d'adaptation d'impédance permettant de réaliser ladite adaptation d'impédance, le choix de celle, parmi ces configurations, qui minimise la consommation de l'amplificateur, et la configuration du réseau d'adaptation d'impédance selon la configuration choisie.

5. Chaîne de réception à radiofréquence comprenant : une antenne (ANT), un amplificateur (LNA) et un réseau d'adaptation d'impédance (RAI) configurable, agencé entre ladite antenne et une entrée dudit amplificateur, **caractérisée en ce qu'**elle comprend aussi :
- des circuits de mesure (CG, CNB) du gain de la chaîne de réception et du niveau de bruit en sortie de l'amplificateur ;
- un dispositif d'accord (DA) dudit réseau d'adaptation d'impédance ; et
- un processeur de données (PD) configuré pour recevoir en entrée des mesures de gain et de niveau de bruit en provenance desdits circuits de mesure et pour fournir en sortie des signaux de pilotage dudit dispositif d'accord ;
**caractérisé en ce que** ledit processeur de données est configuré pour :
- déterminer une impédance (Z_{S}) vue depuis l'entrée de l'amplificateur à partir des mesures en provenance desdits circuits de mesure ;
- calculer une impédance (Z_{ANT}) de l'antenne à partir de l'impédance ainsi déterminée et de la fonction de transfert du réseau d'adaptation d'impédance ; et
- fournir en sortie des signaux de pilotage dudit dispositif d'accord adaptés pour réaliser une adaptation d'impédance entre l'antenne et l'amplificateur.

6. Chaîne de réception à radiofréquence selon la revendication 5 dans laquelle ledit processeur de données est configuré pour déterminer ladite impédance vue depuis l'entrée de l'amplificateur par application d'une table de correspondance.

7. Chaîne de réception à radiofréquence selon l'une des revendications 5 ou 6 dans laquelle ledit circuit de mesure du niveau de bruit en sortie de l'amplificateur est configuré pour mesurer un taux d'erreur binaire d'un signal numérique reçu par ladite chaîne de réception à radiofréquence, et pour calculer ledit niveau de bruit en fonction de ce taux d'erreur binaire.

8. Chaîne de réception à radiofréquence selon l'une des revendications 5 à 7 dans laquelle ledit processeur de données est également configuré pour déterminer une pluralité de configurations du réseau d'adaptation d'impédance permettant de réaliser ladite adaptation d'impédance, choisir celle, parmi ces configurations, qui minimise la consommation de l'amplificateur, et fournir en sortie des signaux de pilotage dudit dispositif d'accord correspondant à la configuration choisie.

## Patentansprüche

1. Verfahren zum automatischen Anpassen der Impedanz einer Funkfrequenzempfangskette, die Folgendes umfasst: eine Antenne (ANT), einen Verstärker (LNA) und ein konfigurierbares Impedanzanpassungsnetz (RAI), angeordnet zwischen der Antenne und einem Eingang des Verstärkers, wobei das Verfahren die folgenden Schritte beinhaltet:
a) Erfassen von wenigstens einem Messwert der Verstärkung (G) der Empfangskette und des Rauschpegels (SNR) am Ausgang des Verstärkers; und
b) Abstimmen des Anpassungsnetzes in Abhängigkeit von den Messwerten;
**dadurch gekennzeichnet, dass** Schritt b) die folgenden Unterschritte beinhaltet:
b1) Bestimmen einer Impedanz (Z_{S}), betrachtet vom Eingang des Verstärkers, auf der Basis der Messwerte von Schritt a);
b2) Berechnen einer Impedanz der Antenne (Z_{ANT}) auf der Basis der im vorherigen Unterschritt bestimmten Impedanz und der Übertragungsfunktion des Impedanzanpassungsnetzes; und
b3) Abstimmen des Anpassungsnetzes, um eine Impedanzanpassung zwischen der Antenne und dem Verstärker zu realisieren.

2. Verfahren nach Anspruch 1, bei dem Unterschritt b1) durch Anwenden einer Korrespondenztabelle durchgeführt wird.

3. Verfahren nach einem der vorherigen Ansprüche, bei dem Schritt a) das Messen einer binären Fehlerrate eines von der Funkfrequenzkette empfangenen digitalen Signals und das Berechnen des Rauschpegels am Ausgang des Verstärkers in Abhängigkeit von dieser binären Fehlerrate beinhaltet.

4. Verfahren nach einem der vorherigen Ansprüche, bei dem Schritt b3) das Bestimmen einer Mehrzahl von Konfigurationen des Impedanzanpassungsnetzes, die das Realisieren der Impedanzanpassung zulassen, das Auswählen derjenigen aus diesen Konfigurationen, die den Verbrauch des Verstärkers minimiert, und das Konfigurieren des Impedanzanpassungsnetzes gemäß der gewählten Konfiguration beinhaltet.

5. Funkfrequenzempfangskette, die Folgendes umfasst: eine Antenne (ANT), einen Verstärker (LNA) und ein konfigurierbares Impedanzanpassungsnetz (RAI), angeordnet zwischen der Antenne und einem Eingang des Verstärkers, **dadurch gekennzeichnet, dass** sie auch Folgendes umfasst:
- Schaltungen (CG, CNB) zum Messen der Verstärkung der Empfangskette und des Rauschpegels am Ausgang des Verstärkers;
- eine Vorrichtung (DA) zum Abstimmen des Impedanzanpassungsnetzes; und
- einen Datenprozessor (PD), konfiguriert zum Empfangen, am Eingang, von Messwerten für Verstärkung und Rauschpegel von den Messschaltungen und zum Anlegen von Steuersignalen der Abstimmungsvorrichtung am Ausgang;
**dadurch gekennzeichnet, dass** der Datenprozessor konfiguriert ist zum:
- Bestimmen einer Impedanz (Z_{S}), betrachtet vom Eingang des Verstärkers auf der Basis von Messwerten von den Messschaltungen;
- Berechnen einer Impedanz (Z_{ANT}) der Antenne auf der Basis der so bestimmten Impedanz und der Übertragungsfunktion des Impedanzanpassungsnetzes; und
- Anlegen von Steuersignalen der Abstimmungsvorrichtung am Ausgang, ausgelegt zum Realisieren einer Impedanzanpassung zwischen der Antenne und dem Verstärker.

6. Funkfrequenzempfangskette nach Anspruch 5, bei der der Datenprozessor zum Bestimmen der Impedanz, betrachtet vom Eingangsverstärker, durch Anwenden einer Korrespondenztabelle konfiguriert ist.

7. Funkfrequenzempfangskette nach Anspruch 5 oder 6, bei der die Schaltung zum Messen des Rauschpegels am Ausgang des Verstärkers zum Messen einer binären Fehlerrate eines von der Funkfrequenzempfangskette empfangenen digitalen Signals und zum Berechnen des Rauschpegels in Abhängigkeit von dieser binären Fehlerrate konfiguriert ist.

8. Funkfrequenzempfangskette nach einem der Ansprüche 5 bis 7, bei der der Datenprozessor auch zum Bestimmen einer Mehrzahl von Konfigurationen des Impedanzanpassungsnetzes, die das Realisieren der Impedanzanpassung zulassen, zum Auswählen derjenigen unter diesen Konfigurationen, die den Verbrauch des Verstärkers minimiert, und zum Anlegen von Steuersignalen der Abstimmungsvorrichtung am Ausgang entsprechend der gewählten Konfiguration konfiguriert ist.

## Claims

1. Automatic impedance-matching method for a radiofrequency reception chain comprising: an antenna (ANT), an amplifier (LNA) and a configurable impedance-matching network (RAI) arranged between said antenna and an input of said amplifier, the method comprising the following steps:
a) acquiring at least one measurement of the gain (G) of the reception chain and of the noise level (SNR) at the output of the amplifier; and
b) tuning said matching network according to said measurements;
**characterized in that** said step b) comprises the following sub-steps:
b1) determining an impedance (Z_{S}) seen from the input of the amplifier on the basis of the measurements from step a);
b2) calculating an impedance (Z_{ANT}) of the antenna on the basis of the impedance determined in the preceding sub-step and of the transfer function of the impedance-matching network; and
b3) tuning said matching network so as to perform impedance matching between the antenna and the amplifier.

2. Method according to Claim 1, in which said sub-step b1) is implemented through application of a lookup table.

3. Method according to one of the preceding claims, in which said step a) comprises measuring a bit error rate of a digital signal received by said radiofrequency reception chain, and calculating said noise level at the output of the amplifier according to this bit error rate.

4. Method according to one of the preceding claims, in which step b3) comprises determining a plurality of configurations of the impedance-matching network allowing said impedance matching to be performed, choosing, from among these configurations, that which minimizes the consumption of the amplifier, and configuring the impedance-matching network according to the chosen configuration.

5. Radiofrequency reception chain comprising: an antenna (ANT), an amplifier (LNA) and a configurable impedance-matching network (RAI), arranged between said antenna and an input of said amplifier, **characterized in that** it also comprises:
- circuits for measuring (CG, CNB) the gain of the reception chain and the noise level at the output of the amplifier;
- a device for tuning (DA) said impedance-matching network; and
- a data processor (PD) configured to receive, as input, gain and noise-level measurements originating from said measuring circuits and to deliver, as output, signals for controlling said tuning device;
**characterized in that** said data processor is configured to:
- determine an impedance (Z_{S}) seen from the input of the amplifier on the basis of the measurements originating from said measuring circuits;
- calculate an impedance (Z_{ANT}) of the antenna on the basis of the impedance thus determined and of the transfer function of the impedance-matching network; and
- deliver, as output, signals for controlling said tuning device, which signals are capable of performing impedance matching between the antenna and the amplifier.

6. Radiofrequency reception chain according to Claim 5, in which said data processor is configured to determine said impedance seen from the input of the amplifier through application of a lookup table.

7. Radiofrequency reception chain according to either of Claims 5 or 6, in which said circuit for measuring the noise level at the output of the amplifier is configured to measure a bit error rate of a digital signal received by said radiofrequency reception chain, and to calculate said noise level according to this bit error rate.

8. Radiofrequency reception chain according to one of Claims 5 to 7, in which said data processor is also configured to determine a plurality of configurations of the impedance-matching network allowing said impedance matching to be performed, to choose, from among these configurations, that which minimizes the consumption of the amplifier, and to deliver, as output, signals for controlling said tuning device corresponding to the chosen configuration.
